# EUROPÄISCHE PATENTSCHRIFT

(11) **EP 1 451 847 B1**
(45) Veröffentlichungstag und Bekanntmachung des Hinweises auf die Patenterteilung: **23.07.2008**
(21) Anmeldenummer: 02787413.0
(22) Anmeldetag: 03.12.2002
(51) Int. Cl.: H01J 37/153

(54) **TEILCHENOPTISCHER KORREKTOR**
OPTICAL PARTICLE CORRECTOR
CORRECTEUR EN OPTIQUE DES PARTICULES

(30) Priorität: 04.12.2001 DE 10159308
(43) Veröffentlichungstag der Anmeldung: 01.09.2004
(73) Patentinhaber: Ceos Corrected Electron Optical Systems GmbH, 69126 Heidelberg (DE)
(72) Erfinder: MÜLLER, Heiko, 69126 Heidelberg (DE); ROSE, Harald, 64287 Darmstadt (DE)
(74) Vertreter: Pöhner, Wilfried Anton, Dr.
(86) Internationale Anmeldenummer: PCT/DE2002/004431
(87) Internationale Veröffentlichungsnummer: WO 2003/049140

(56) Entgegenhaltungen:
- DE-A- 4 204 512
- US-A- 2 919 381
- ZACH J ET AL: "Aberration correction in a low voltage SEM by a multipole corrector" NUCLEAR INSTRUMENTS & METHODS IN PHYSICS RESEARCH, SECTION - A: ACCELERATORS, SPECTROMETERS, DETECTORS AND ASSOCIATED EQUIPMENT, NORTH-HOLLAND PUBLISHING COMPANY. AMSTERDAM, NL, Bd. A363, Nr. 1, 1995, Seiten 316-325, XP004009662 ISSN: 0168-9002
- BARANOVA L A ET AL: "Minimisation of the aberrations of electrostatic lens systems composed of quadrupole and octupole lenses" INTERNATIONAL JOURNAL OF MASS SPECTROMETRY, ELSEVIER SCIENCE PUBLISHERS, AMSTERDAM, NL, Bd. 189, Nr. 1, 8. Juli 1999 (1999-07-08), Seiten 19-26, XP004171412 ISSN: 1387-3806

## Beschreibung

Die Erfindung betrifft einen mit Multipolelementen in Form elektrischer und/oder magnetischer Quadrupol- und Oktopolelemente ausgestatteten Korrektor mit gerader optischer Achse zur Beseitigung des Farbfehlers und des Öffnungsfehlers von teilchenoptischen Linsen.

Teilchenoptische Systeme werden mit Erfolg sowohl in vergrößernden Systemen, wie den Elektronenmikroskopen, als auch verkleinernden Systemen, wie bei der Elektronenprojektionslithographie, eingesetzt. Gegenüber lichtoptischen Systemen bieten sie den Vorteil einer wesentlich höheren Auflösung, wobei diese Größe um so besser ausfällt, je kleiner die Wellenlänge der eingesetzten Strahlen ist. Bei Einsatz von Elektronenstrahlen bedeutet dies etwa einen Auflösungsgewinn um den Faktor 10⁴ gegenüber Licht.

Eine weitere Verbesserung der Auflösung von teilchenoptischen Systemen erfordert eine Korrektur der den abbildenden Linsen eigenen Bildfehler. Entsprechend der üblichen Nomenklatur werden diese Bildfehler unterteilt in:
axiale Bildfehler welche bei Abbildung eines Achsenpunktes auftreten und nur vom Öffnungswinkel abhängig sind. Sie werden bestimmt durch den Verlauf der von einem Achsenpunkt der Gegenstandsebene ausgehenden, im x- und y-Schnitt liegenden axialen Fundamentalbahnen (x_{α}), (y_{β}).
außeraxiale Bildfehler, die bei Abbildung eines außeraxialen Bildpunktes zur Wirkung kommen und vom Abstand zur optischen Achse (und in der Regel vom Öffnungswinkel) abhängen. Sie werden bestimmt durch den Verlauf der von einem achsenfernen Punkt der Gegenstandsebene ausgehenden, im x- und y-Schnitt liegenden außeraxialen Fundamentalbahnen (x_{γ}), (y_{δ}).
chromatische Fehler die bei abbildenden Teilchen unterschiedlicher Geschwindigkeit auftreten, in axiale und außeraxiale Farbfehler weiter unterteilt sind und dementsprechend vom Öffnungswinkel und/oder vom Abstand zur optischen Achse abhängen.

Dabei ist für die axialen Fehler, da sie nur vom Öffnungswinkel abhängen, auch die Bezeichnung Öffnungsfehler üblich und für die axialen und außeraxialen Bildfehler zusammen zur Abgrenzung gegenüber den chromatischen Bildfehlern auch der Begriff geometrische Bildfehler in Gebrauch.

Zur Korrektur dieser Bildfehler, insbesondere der chromatischen Aberration (= axialer Farbfehler 1. Ordnung) und der sphärischen Aberration (= Öffnungsfehler 3. Ordnung), sind in der Vergangenheit erhebliche Anstrengungen unternommen worden. Die bisher besten Erfolge hat man dabei mit optischen Systemen erreicht, in denen anstelle rotationssymmetrischer Felder die Felder von Multipolen, insbesondere Quadrupolen und Oktopolen, verwendet werden. Systeme dieser Art werden im allgemeinen unter dem Namen Korrektiv oder Korrektor geführt.

Im Stand der Technik sind Korrektive oder Korrektoren unterschiedlicher Bauart bekannt.

In der DE 4204512 A1 wird ein elektronenoptisches Korrektiv offenbart, das aus 6 Quadrupolelementen und 7 Oktopolelementen aufgebaut ist, wobei je drei Quadrupole und Oktopole vor und hinter der Mittelebene des Systems und ein weiterer Oktopol in der Mittelebene angeordnet sind. Das System ermöglicht die simultane Korrektur des axialen und außeraxialen Farbfehlers und der sphärischen Aberration. Sein Vorteil liegt in einem einfachen Aufbau, einer relativ geringen Anzahl von Multipolelementen und einer vergleichsweise geringen Baulänge begründet. Als Nachteil dieses Systems gilt jedoch, daß bei Anwendungen im Bereich der Höchstauflösung an die elektrische Versorgung extrem hohe Stabiltätsanforderungen gestellt werden, die bisher nicht erfüllbar sind. Darüber hinaus ist die Größe des Bildfeldes einer mit vorliegendem Korrektiv korrigierten Objektivlinse in nachteiliger Weise eingeschränkt, da die außeraxialen Bildfehler 3. Ordnung der Linse mit diesem System nicht korrigierbar sind.

Ein Korrektor zur Beseitigung des Farbfehlers mit rein elektrischen Feldern wird in der DE 199 26 927.0 vorgestellt. Der hier vorgeschlagene Korrektor weist zwei Korrekturstücke auf, die entlang der optischen Achse hinter einander angeordnet sind und jeweils elektrische Quadrupolfelder und überlagerte Oktopolfelder erzeugen. Der Korrektor ermöglicht eine Korrektur des axialen Farbfehlers 1. Ordnung und des Öffnungsfehlers 3. Ordnung. Der Vorteil dieses Korrektors gegenüber dem vorbenannten liegt darin, daß die zur Korrektur erforderlichen Felder rein elektrostatischer Natur sind, diese sich daher präzise und vor allem reproduzierbar einstellen lassen. Infolge der fehlenden Korrektur außeraxialer Fehler ist eine hohe Auflösung in nachteiliger Weise jedoch nur in extrem achsennahen Bereichen erreichbar, so daß die nutzbare Bildfeldgröße stark eingeschränkt ist.

Des weiteren ist aus der DE 100 01 277.9 auch ein Korrektor bekannt, bei dem in Abweichung zur hier benutzten Methode, die Korrektur von Bildfehlern mit einem Satz von Hexapolen durchgeführt wird, die jeweils im Wechsel mit Rundlinsen entlang der optischen Achse angeordnet sind. In Abweichung zu den vorbenannten Korrektoren weist der hier vorgeschlagene stigmatische Zwischenbilder auf. Diese Ausführung ermöglicht eine Korrektur aller geometrischen Fehler der 3. Ordnung und stellt vergleichsweise geringe Anforderungen der Stabilität der elektrischen Versorgung. Ein erheblicher Nachteil dieser Lösung liegt jedoch darin, daß mit dem vorliegenden Korrektor eine Korrektur der Farbfehler nicht möglich ist. Darüber hinaus werden durch die als Transferlinsen wirkenden Rundlinsen zusätzliche axiale Farbfehler erzeugt. Auch die stigmatischen Zwischenbilder führen aufgrund des in diesen Bereichen auftretenden Boersch-effekts zu einer zusätzlichen Energieverbreiterung der Elektronen. Zudem weist der Korrektor in nachteiliger Weise eine vergleichsweise große Baulänge auf ist daher nur bedingt einsetzbar.

Vor diesem Hintergrund hat sich die Erfindung die Aufgabe gestellt, einen Korrektor anzugeben, der sich durch vergleichsweise niedrige Stabilitätsanforderungen an die elektrische Versorgung auszeichnet, eine Korrektur des axialen und außeraxialen Farbfehlers 1. Ordnung, aller geometrischen Fehler 3. Ordnung und des Öffnungsfehlers 5. Ordnung einer teilchenoptischen Rundlinse ermöglicht. Darüber hinaus erzeugt der Korrektor während der Korrektur selbst keine geometrischen Fehler 4. Ordnung.

Gelöst wird diese Aufgabe erfindungsgemäß dadurch, daß
- wenigstens zwölf Quadrupolelemente und zehn Oktopolelemente vorgesehen sind,
   - von denen je drei Quadrupolelemente und zwei Oktopolelemente zu einer Gruppe zusammengefaßt sind,
   - die Gruppen entlang der optischen Achse hintereinander angeordnet sind
   - die Multipolelemente von Gruppe zu Gruppe sich jeweils paarweise einander entsprechen,
   - die Multipolelemente der jeweils folgenden Gruppe jeweils in umgekehrter Reihenfolge entlang der optischen Achse positioniert sind wie die entsprechenden Multipolelemente der jeweils vorangehenden Gruppe,
   - und der Aufbau der jeweils einander entsprechenden Multipolelemente jeweils spiegelsymmetrisch zur jeweiligen Mittelebene zwischen den Gruppen ist,
   - die Mittelebene zwischen erster und zweiter Gruppe eine erste,
   - die Mittelebene zwischen zweiter und dritter Gruppe eine zweite
   - und die Mittelebene zwischen dritter und vierter Gruppe eine dritte Symmetrieebene definiert,
- wenigstens zwei Quadrupolelemente elektrische und magnetische Quadrupolfelder erzeugen,
   - wobei diese Quadrupolelemente vorzugsweise spiegelsymmetrisch zur zweiten oder zu allen Symmetrieebenen angeordnet sind,
- und jeweils ein weiteres Oktopolelement in der ersten und dritten Symmetrieebene vorgesehen ist.

Der Korrektor gemäß vorliegender Erfindung besteht aus vier Dreiergruppen, die entlang der optischen Achse hintereinander angeordnet sind und jeweils drei Quadrupole und zwei Oktopole aufweisen. Dabei sind die Oktopole so angeordnet, daß deren Felder die Quadrupolfelder überlagern. Die Anzahl der jeweils unterschiedlichen Elemente wird dadurch eingeschränkt, daß die Multipolelemente von Gruppe zu Gruppe sich jeweils paarweise einander entsprechen. Die Vielfalt der Elemente wird hierdurch von 4 mal 5 Elementen auf 1 mal 5 Elemente reduziert. Dabei sind die Multipolelemente der jeweils folgenden Gruppe jeweils in umgekehrter Reihenfolge entlang der optischen Achse positioniert wie die entsprechenden Multipolelemente der jeweils vorangehenden Gruppe.

Die vorgeschlagene Ausgestaltung beschreibt ein System mit hoher Symmetrie, die sich in einem doppelsymmetrischen Aufbau manifestiert. Dementsprechend ist die erste Systemhälfte symmetrisch zur Mittelebene der ersten Systemhälfte, die zweite Systemhälfte symmetrisch zur Mittelebene der zweiten Systemhälfte und das ganze System symmetrisch zu Mittelebene des Gesamtsystems aufgebaut. Die genannten Mittelebenen sind gleichzeitig Mittelebene zwischen den jeweils benachbarten Gruppen und definieren in Richtung des Strahlenganges eine erste, zweite und dritte Symmetrieebene. Die Brechkräfte der Quadrupole in der ersten Hälfte des Systems werden vorzugsweise antisymmetrisch zu den Brechkräften in der zweiten Hälfte des Systems eingestellt. Alternativ ist auch die symmetrische Wahl der Brechkräfte vorgesehen.

Die antisymmetrische Wahl hat den entscheidenden Vorteil, dass der Korrektor keine Aberrationen mit zweizähliger Symmetrie einführt.

Von den genannten Quadrupolen sind wenigstens zwei, vorzugsweise jedoch mehr als zwei Quadrupolelemente so ausgebildet, daß sie elektrische und magnetische Quadrupolfelder erzeugen. Dabei sind diese elektrisch-magnetischen Quadrupole vorzugsweise spiegelsymmetrisch zur zweiten oder zu allen Symmetrieebenen angeordnet. Das System wird komplettiert durch jeweils ein weiteres Oktopolelement, das in der ersten und dritten Symmetrieebene vorgesehen ist.

Gemäß einer in Unteranspruch 18 beschriebenen Weiterbildung der Erfindung können die optischen Eigenschaften des Gesamtsystems bestehend aus vorgeschalteten teilchenoptischen Linsen und Korrektor bei der Übertragung von sehr großen Bildfeldern mit großer Bildpunktzahl dadurch verbessert werden, daß in den ersten und dritten Symmetrieebene unter Erhaltung der Doppelsymmetrie für den Korrektor jeweils ein weiterer rein magnetischer oder elektrisch-magnetischer Quadrupol positioniert wird. Die Anzahl der Quadrupolelemente im Korrektor steigt bei dieser Weiterbildung auf 14.

Wesentliche Überlegungen zur Korrektur von Bildfehlern mit unrunden Multipolelemente führen dazu, den Korrektor mit einer hohen Symmetrie auszustatten. Die beim erfindungsgemäßen Korrektor gegebene Doppelsymmetrie hat dementsprechend weitreichende Auswirkungen auf die elektrische Versorgung der einzelnen Multipolelemente und die Größe und Art der Bildfehler innerhalb des Korrektors.

Aufgrund der gegebenen Symmetrie werden einander entsprechende Multipolelemente in den einzelnen Gruppen jeweils mit gleichen Strömen bzw. Spannungen beaufschlagt. Hierdurch wird einerseits die Anzahl der zur elektrischen Versorgung notwendigen Geräte beträchtlich vermindert und als Folge davon in vorteilhafter Weise der konstruktive und materielle Aufwand für die elektrische Versorgung der einzelnen Elemente erheblich vereinfacht. Andererseits führt die symmetrische Ausführung des Korrektors auch dazu, daß Schwankungen der Ströme und Spannungen nur einen geringen oder keinen Einfluß auf die Stabilität des Gesamtsystems ausüben, da die auf symmetrisch ausgebildete Elemente einwirkenden Störungen sich ganz oder teilweise aufheben. An die Strom- und Spannungsversorgung werden bei dem vorgeschlagenem System daher geringere Anforderungen gestellt. Bei Standardanwendungen des vorgeschlagenen Systems führt dies zu vergleichsweise einfachen und daher kostengünstigen Versorgungseinheiten, bei Anwendungen im Bereich der Höchstauflösung ist hierdurch sichergestellt, daß die geforderten Stabilitätsanforderungen mit den im Stand der Technik verfügbaren Komponenten erreichbar sind.

Die dargelegte Symmetrie führt auch zu einer wesentlichen Vereinfachung bei der Einstellung der zur Korrektur erforderlichen Felder. Durch die Vorgabe gleicher Potentiale oder Ströme an den verschiedenen Multipolelementen des Korrektors wird die an sich gegebene Vielfalt der Einstellmöglichkeiten eines Korrektors erheblich reduziert, die Durchführung der Korrektur wird hierdurch wesentlich vereinfacht.

Durch den Aufbau des Korrektors aus vier Dreiergruppen, die jeweils mit elektrisch-magnetischen Quadrupolen ausgestattet sind, kann die Korrektur des Farbfehlers auf mehrere gleichartige Korrekturstücke aufgeteilt werden. Die Korrekturbeiträge aus den einzelnen Gruppen summieren sich dann zur Gesamtkorrektur auf, wobei jeder Beitrag für sich genommen vergleichsweise schwach ist. Dementsprechend fällt auch die Erregung der zur Korrektur notwendigen elektrisch-magnetischen Quadrupole geringer aus, als bei Korrektoren nach dem Stand der Technik. Die vorteilhafte Folge hiervon ist ebenfalls eine Verminderung der Stabilitätsanforderungen an die elektrischen Versorgungen.

Der doppelsymmetrische Aufbau des Korrektors gemäß vorliegender Erfindung führt zu einem symmetrischen / antisymmetrischen Verlaufs der Bahnen und der zugeordneten Felder. Dies hat weitreichende Konsequenzen für den Einfluss von einzelnen geometrisch optischen Fehlern, da bestimmte Beiträge allein aus Gründen der Symmetrie nicht auftreten können. Die vorteilhafte Folge hiervon ist, daß die Auflösung des teilchenoptischen Systems auch außerhalb des achsennahen Bereichs essentiell verbessert wird.

Im Ergebnis stellt der vorgeschlagene Korrektor bei vergleichsweise niedrigen Stabilitätsanforderungen an die elektrische Versorgung geeignete Mittel zur Korrektur des axialen Farbfehlers (1. Ordnung) und aller geometrischen Fehler 3. Ordnung, zur Korrektur des außeraxialen Farbfehlers, sowie des Öffnungsfehlers 5. Ordnung einer teilchenoptischen Rundlinse zu Verfügung. Dabei erzeugt der Korrektor selbst keine geometrischen Fehler 4. Ordnung. Die Korrektur der Fehler wird durch geeignete Einstellungen der Multipolelemente und deren Anordnung auf der optischen Achse, die in Unteransprüchen aufgezeigt sind, umgesetzt.

Bei einer bevorzugten Ausführungsform des erfindungsgemäßen Korrektors sind die Multipolelemente so angeordnet, daß die erste Gruppe
- eingangsseitig ein Quadrupolelement zur Erzeugung von elektrischen und/oder magnetischen Quadrupolfeldern (magnetischer Quadrupol) und in dessen unmittelbarer Nähe ein Oktopolelement aufweist,
- gefolgt von einem zweiten Quadrupolelement zur Erzeugung von elektrischen und magnetischen Quadrupolfeldern und einem Oktopolelement in dessen unmittelbarer Nähe,
- und ausgangsseitig ein Quadrupolelement zur Erzeugung von elektrischen und magnetischen Quadrupolfelder ( = elektrisch-magnetischer Quadrupol) angeordnet ist.

Aufgrund der vorgegebenen Doppelsymmetrie wiederholt sich dieser Aufbau in jeder Gruppe in jeweils umgekehrter Reihenfolge zur jeweils vorherigen Gruppe. Die von einem Objektpunkt ausgehenden Strahlen durchlaufen nach Durchtritt durch das Objektiv bei vorliegender Ausführungsform damit der Reihe nach folgende Felder:

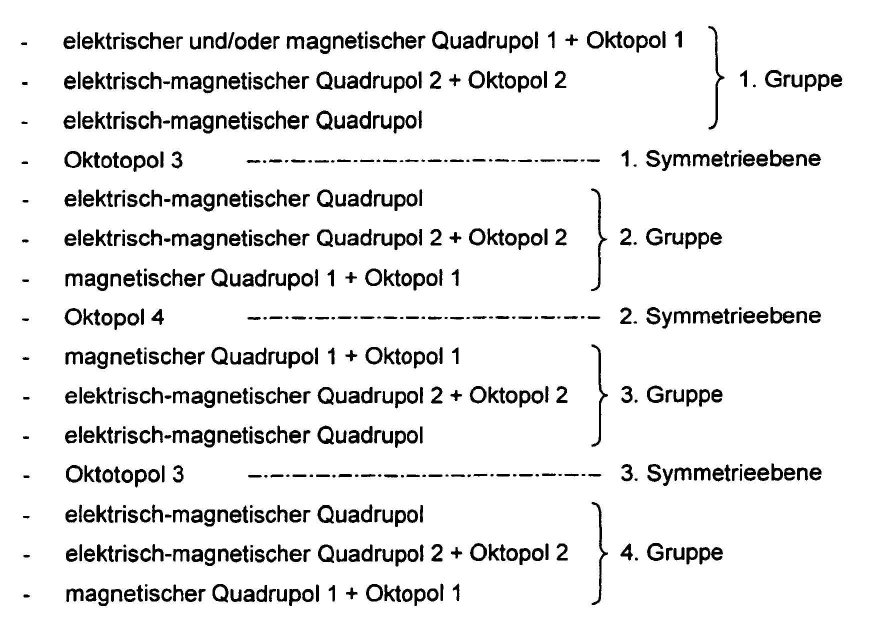

Die Quadrupolfelder bestimmen dabei den Gaußschen (paraxialen) Strahlengang. Nach einem Merkmal der Erfindung werden die Brechkräfte der magnetischen Quadrupole und die Gesamtbrechkräfte der elektrisch-magnetisch Quadrupole jeweils so eingestellt, daß
- die erste axiale Fundamentalbahn (x_{α}) punktsymmetrisch (antisymmetrisch) zur ersten Symmetrieebene,
- die zweite axiale Fundamentalbahn (y_{β}) spiegelsymmetrisch zur ersten Symmetrieebene verläuft,
- die erste außeraxiale Fundamentalbahn (x_{γ}) spiegelsymmetrisch zur ersten Symmetrieebene,
- die zweite außeraxiale Fundamentalbahn (y_{δ}) punktsymmetrisch zur ersten Symmetrieebene verläuft.

Bei antisymmetrischer Wahl der Brechkräfte in der ersten und zweiten Hälfte des Systems vertauschen in der mittleren Symmetrieebene die Bahnen den xz-Schnitts und die zugehörigen Bahnen des yz-Schnitts ihre Rollen.

Bei symmetrischer Wahl der Brechkräfte in der ersten und zweiten Hälfte des Systems verlaufen die axialen Bahnen symmetrisch zur mittleren Symmetrieebene und die außeraxialen Bahnen antisymmetrisch.

Der Strahlengang der axialen und außeraxialen Teilchenbündel durch den Korrektor sieht dabei folgendermaßen aus:

Die von einem Objektpunkt auf der optischen Achse ausgehenden Strahlen erfahren bei Eintritt in den Korrektor durch den ersten Quadrupol eine astigmatische Aufspaltung, wodurch die im x- bzw. y-Schnitt verlaufenden Bahnen in unterschiedliche Richtungen abgelenkt werden. Das axiale bzw. außeraxiale Teilchenbündel wird hierdurch in einem Schnitt, beispielsweise im y-Schnitt jeweils fokussiert, während es im anderen Schnitt, dem x-Schnitt, jeweils aufgeweitet wird. Bei jedem der nachfolgenden Quadrupole wiederholen sich Fokussierung und Defokussierung der Strahlen in beiden Schnitten um jeweils definierte Beträge, so daß der ganze Strahlengang und alle Zwischenbilder innerhalb des Korrektivs astigmatisch ausfallen. Der letzte Quadrupol sorgt dann dafür, daß sowohl beim axialen als auch außeraxialen Teilchenbündel der Astigmatismus wieder aufgehoben und Rotationssymmetrie wieder hergestellt wird. Beide Teilchenbündel verlassen den Korrektor daher ohne Aufspaltung.

Jede der vier Dreiergruppen von Quadrupolelementen enthält für einen Schnitt zwei fokussierende und ein defokussierendes Element und für den anderen Schnitt ein fokussierendes und zwei defokussierende Elemente. Die Felder der Korrektorquadrupole greifen dabei im wesentlichen nur an den aufgeweiteten Strahlen an, wodurch deren Bahnverlauf eine erhebliche Beeinflussung und einen negativen Beitrag zum Farbfehler erfahren. Die nahe der optischen Achse verlaufenden Bahnen werden durch die Felder der Quadrupole hingegen wenig beeinflußt, die Beiträge zur Änderung des Farbfehlers fallen in diesen Bereichen daher gering aus.

Zur Korrektur des axialen und außeraxialen Farbfehlers werden die Brechkräfte der Quadrupolfelder in geeigneter Größe vorgegeben. Sie bestimmen den Gaußschen Strahlengang, wobei hierfür jeweils nur die Gesamtbrechkräfte entscheidend sind. Bei den elektrisch-magnetischen Quadrupolen lassen sich daher die von den magnetischen und elektrischen Feldern herrührenden Anteile der Brechkräfte zueinander variieren, ohne daß der paraxiale Strahlengang beeinflußt wird. Diese Eigenschaft wird in an sich bekannter Weise zur Korrektur des Farbfehlers genutzt. Dabei wird die Aufteilung der Quadrupolbrechkräfte in einen elektrischen und einen magnetischen Anteil unter Beibehaltung der Gesamtbrechkraft als Parametersatz zur Elimination der chromatischen Fehler eingesetzt. Gemäß einem Merkmal der Erfindung lassen sich die Stärken der elektrischen und magnetischen Quadrupolfelder so vorgeben, daß sich der axiale Farbfehler und/oder der außeraxiale Farbfehler von Korrektor und Objektiv kompensieren.

Bei der konkreten Auswahl der Quadrupole die kombiniert elektrisch-magnetisch ausgebildet werden, besteht eine gewisse Freiheit. Wesentlich ist nur, daß hinreichend viele Freiheitsgrade zur kompensatorischen Einstellung der axialen und/oder außeraxialen Farbfehlerbeiträge sowohl im x- als auch im y-Schnitt vorhanden sind.

Die Korrektur des Öffnungsfehlers 3. Ordnung und der außeraxialen geometrischen Fehler 3. Ordnung erfolgt durch die Oktopole. Um eine vollständige Korrektur dieser Fehler zu erreichen ist - einer wesentlichen Überlegung der Erfindung entsprechend - ein doppelsymmetrischer Aufbau des Korrektors und eine symmetrische Positionierung der Oktopole erforderlich. Bei der oben definierten bevorzugten Ausführungsform des Korrektors befindet sich jeweils ein Oktopol in der ersten und dritten Symmetrieebene. Dieses symmetrische Paar dient der Korrektur des Offnungsfehlers 3. Ordnung. Die Korrektur der außeraxialen Fehler 3. Ordnung, insbesondere des Feldastigmatismus und der Bildfeldwölbung, wird mittels der verbleibenden Oktopole durchgeführt, welche den elekrisch-magnetischen Quadrupolen einer jeden Gruppe überlagert bzw. zwischen diesen positioniert sind. Der in der Mittelebene des Gesamtsystems angeordnete weitere Oktopol ist zur Korrektur des Offnungsfehlers 5. Ordnung vorgesehen.

Die Einstellung der genannten Oktopole umfaßt eine große Vielfalt an Möglichkeiten. Gemäß vorliegender Erfindung ist insbesondere vorgesehen, die Stärken der Oktopolelemente so einzustellen, daß
- sich alle geometrischen Fehler 3. Ordnung von Korrektor und teilchenoptischer Linse jeweils kompensieren,
- der Öffnungsfehler 5. Ordnung von Korrektor und teilchenoptischer Linse sich kompensieren.
- der Offnungsfehler 3. Ordnung und/ oder der Offnungsfehler 5. Ordnung des aus Korrektor und teilchenoptischer Linse bestehenden Gesamtsystems einen vorgebbaren, definierten Wert annehmen.

Dabei ist die letztgenannte Einstellung insbesondere bei der Erzeugung von Phasenkontrastbildern in der hochauflösenden Transmissionselektronenmikroskopie von Interesse. Hierbei erhält man optimalen Kontrast und maximale Objektinformation, wenn der axiale Fehler 3. und 5. Ordnung des Gesamtsystems jeweils definierte Werte annehmen. In diesem Anwendungsfall ist es daher erforderlich, die genannten Fehler des Gesamtsystems nicht zu eliminieren, sondern auf bestimmte Werte einzustellen.

Nach einem Merkmal der Erfindung können die Oktopolfelder auch den Quadrupolfeldern überlagert werden. Bei vorliegendem Korrektor wird dies dahingehend genutzt, daß die zur Korrektur des Öffnungsfehlers eingesetzten Oktopolfelder den Feldern der innerhalb der einzelnen Gruppen angeordneten Quadrupole überlagert sind.

Bei einer bevorzugten Ausführungsform des erfindungsgemäßen Korrektors werden Multipolelemente eingesetzt, die sowohl Quadrupolfelder als auch Oktopolfelder erzeugen. Damit wird einerseits die Übersichtlichkeit des Korrektors verbessert, andererseits werden die Kosten zu dessen Herstellung wesentlich gesenkt.

Der vorgeschlagene Korrektor kann mit Vorteil in unterschiedlichen teilchenotischen Systemen eingesetzt werden.

Bevorzugte Verwendung findet der Korrektor gemäß vorliegender Erfindung in vergrößernden teilchenoptischen Systemen. Er wird hier insbesondere in der hochauflösenden Transmissionselektronenmikroskopie (TEM) eingestzt, um die Bildfehler des Objektivs zu kompensieren. Für diesen Fall ist eine Anordnung des Korrektors - bei Blick in Strahlrichtung - hinter der Objektivlinse vorgesehen.

Während bei Einsatz von Hexapolkorrektoren nach dem Stand der Technik der Farbfehler unkorrigierbar ist, ermöglicht der Korrektor gemäß vorliegender Erfindung eine gleichzeitige Korrektur von Farb- und Offnungsfehler. Da die Elektronen der zur Beleuchtung des Objekts eingesetzten Elektronenquellen stets eine endliche Energiebreite aufweisen, wird durch Elimination der Farbfehler 1. Ordnung eine wesentliche Beschränkung aufgehoben. Für Phasenkontrastaufnahmen ist auch von Bedeutung, daß vorliegender Korrektor die Einstellung des Öffnungsfehlers 3. und 5. Ordnung auf definierte Werte ermöglicht, da optimaler Kontrast und maximale Objektinformation bei Werten ungleich Null der genannten Fehler vorliegen.

Durch die Entwicklung größerer CCD-Kameras wird in der hochauflösenden Mikroskopie, insbesondere bei Anwendungen in der Strukturbiologie, auch eine große Bildfeldgröße gefordert. Vorliegende Erfindung kommt diesen Anforderungen durch Korrektur der außeraxialen Bildfehler 3. Ordnung nach.

Die in der hochauflösenden Mikroskopie bisher problematischen hohen Stabilitätsanforderungen an die elektrischen Versorgungen werden durch den Korrektor gemäß vorliegender Erfindung ebenfalls entschärft. Aufgrund der hohen Symmetrie des Systems werden Schwankungen der Ströme und Spannungen zum großen Teil kompensiert und wirken sich daher nicht auf das Gesamtsystem aus.

Gemäß einem Merkmal der Erfindung ist auch die Verwendung des erfindungsgemäßen Korrektors in Elektronenmikroskopen mit großem Polschuhspalt, vorzugsweise im Bereich der "in-situ"-Elektronenmikroskopie, vorgesehen. Der große Polschuhspalt ist bei genannten Mikroskopen erforderlich, um ausreichend Platz zur Manipulation der Probe in der Objektkammer zu erhalten. Derartige Linsen weisen einen sehr großen Farbfehler auf. Um Abbildungen mit geringer Beleuchtung und kurzen Belichtungszeiten zu ermöglichen, sind große Energiefenster, d.h. Elektronen mit einem breiten Energiespektrum, notwendig. Diese Randbedingungen führten bisher zu der nachteiligen Folge, daß nur sehr geringe Auflösungen erreichbar waren. Da vorliegende Erfindung die fehlerarme Übertragung großer Energiefenster ermöglicht, können durch Einsatz des erfindungsgemäßen Korrektors auch bei Linsen mit großem Polschuhabstand hohe Auflösungen erzielt werden. Dabei ist die Korrektur der geometrischen Bildfehler 3. Ordnung auch für die genannte Anwendung von Interesse, da auch hier große Bildfelder erwünscht sind.

Ein weiterer Einsatz des Korrektors ist gemäß vorliegender Erfindung in verkleinernden optischen Systemen, insbesondere der Elektronenprojektionslithographie, vorgesehen. Diese Systeme werden dazu genutzt, definierte auf einer Maske angebrachte Strukturen auf einen in der Bildebene befindlichen Kristall (Wafer) verkleinert abzubilden und durch die auftreffenden Elektronen einzuprägen. Für diesen Anwendungsfall werden kurzbrennweitige Elektronenlinsen benötigt, die einen möglichst großen Bereich der Maske auf den Wafer abbilden. Dabei führt die übliche Verwendung von Streukontrastmasken zu einer starken Energieverbreiterung des abbildenden Teilchenstrahls. Im Gegensatz zu anderen Korrektursystemen bietet die vorliegende Erfindung hier die Möglichkeit, aufgrund der Farbfehlerkorrektur auch Teilchenstrahlen mit großem Energiespektrum in einer hohen optischen Qualität abzubilden. Die erforderliche Bildfeldgröße wird bei Einsatz des vorgeschlagenen Korrektors durch die Korrektur der außeraxialen geometrischen Bildfehler 3. Ordnung sichergestellt.

In diesem Anwendungsfall ist die in Unteranspruch 18 beschriebene Weiterbildung der Erfindung besonders vorteilhaft, da sie die optische Qualität der Abbildung sehr großer Bildfehler weiter verbessert, was den konstruktiven Mehraufwand rechtfertigen kann.

Weitere Einzelheiten, Merkmale und Vorteile der Erfindung lassen sich dem nachfolgenden Teil der Beschreibung entnehmen. In diesem Teil werden der Aufbau und Strahlengang des erfindungsgemäßen Korrektors anhand einer beigefügten Zeichnung näher erläutert. Es zeigen
- Figur 1:: Längsschnitt durch den Korrektor in einer stark vereinfachten Darstellungsweise
- Figur 2:: Verlauf der Fundamentalbahnen durch den Korrektor für eine bevorzugte Ausführungsform.

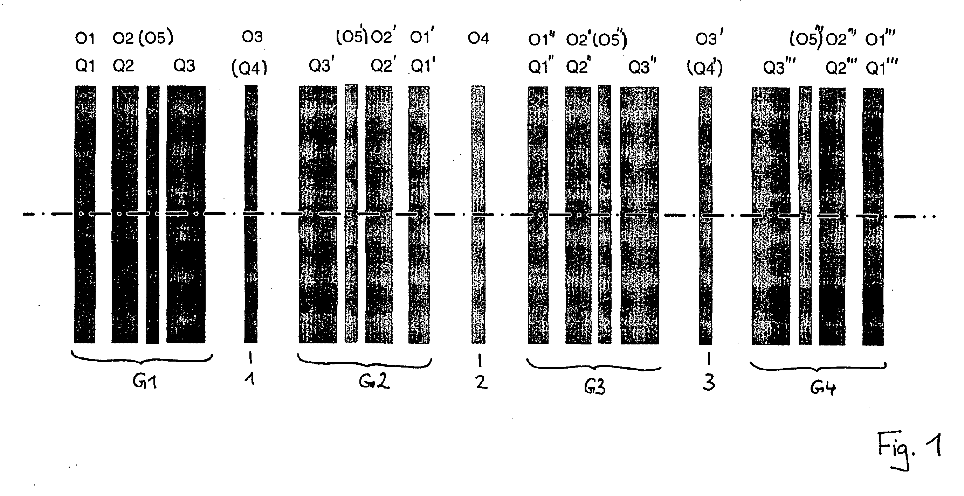

In Figur 1 ist der prinzipielle Aufbau des Korrektors für ein Ausführungsbeispiel wiedergegeben, wobei die verschiedenen Multipolelemente durch unterschiedlich ausgebildete Rechtecke wiedergegeben sind. Dabei kennzeichnen die Bezugszeichen
Q1, Q2, Q3, ...... Q1''', Q2''', Q3'''' und Q4, Q4' Quadrupole,
O1, O2, ..... O1''', O2'" und O3, O3' und O4 und O5, .... O5"' Oktopole.

Die gleiche Ziffern aufweisenden Elemente sind dabei jeweils gleich ausgebildet. Die Quadrupolelemente und die Oktopolelemente sind jeweils zu einer Gruppe G1 - G4 zusammengefaßt. Wie der Figur zu entnehmen ist, entsprechen sich die Multipolelemente von Gruppe zu Gruppe paarweise (Q1 und Q1', Q1' und Q1", etc.), wobei die Multipolelemente der jeweils folgenden Gruppe (z.B. Q3', Q2', Q1') jeweils in umgekehrter Reihenfolge entlang der optischen Achse 4 positioniert sind, wie die entsprechenden Multipolelemente der jeweils vorangehenden Gruppe (z.B. Q1, Q2, Q3).

Bedingt durch diese Anordnung weist der vorliegende Korrektor eine hohe Symmetrie auf, wobei die Symmetrieebenen in den jeweiligen Mittelebenen zwischen den einzelnen Gruppen G1 - G4 liegen. Somit ist zwischen erster und zweiter Gruppe G1/G2 eine erste 1, zwischen zweiter und dritter Gruppe G2/G3 eine zweite 2 und zwischen dritter und vierter Gruppe G3/G4 eine dritte Symmetrieebene 3 definiert. Dabei ist die Position der einzelnen Multipolelemente spiegelsymmetrisch zu den genannten Symmetrieebenen vorgegeben.

Bei vorliegender Ausführung sind die Quadrupole Q2, Q3 und die gleich ausgebildeten Quadrupole Q2', Q3'; Q2", Q3"; Q2''', Q3''' als elektrisch-magne-tische Elemente vorgegeben. Die durch sie erzeugten elektrischen und magnetischen Quadrupolfelder werden zur Korrektur des Farbfehlers 1. Ordnung genutzt.

Optional sind zwei elektrisch-magnetische Quadrupole (Q4, Q4') vorgesehen, deren Brechkräfte in paraxialer Näherung vollständig kompensiert sind.

Die Oktopolelemente O1- O5 dienen der Korrektur des Öffnungsfehlers 3. Ordnung, der außeraxialen geometrischen Fehler 3. Ordnung und des Öffnungsfehlers 5. Ordnung. Dabei erfolgt die Korrektur der außeraxialen Fehler 3. Ordnung, insbesondere des Feldastigmatismus und der Bildfeldwölbung, mittels der Oktopole O1 - O5'''. Das symmetrisch zur Mittelebene 2 des Gesamtsystems angeordnete Paar O3, O3' übernimmt die Korrektur des Öffnungsfehlers 3. Ordnung, der in der Mittelebene 2 angeordnete Oktopol 04 die Korrektur des Öffnungsfehlers 5. Ordnung.

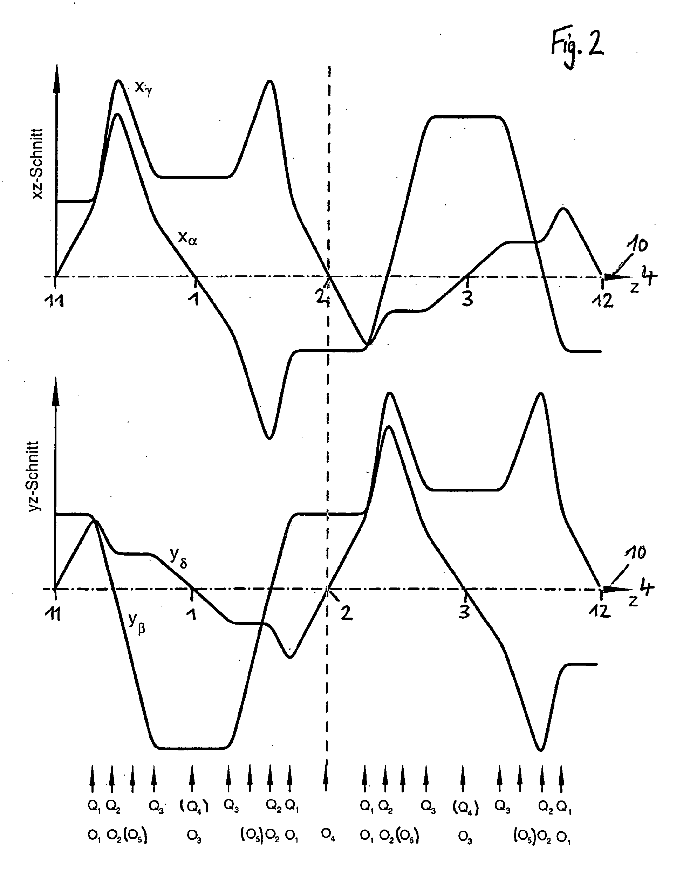

In Figur 2 ist der teleskopische Strahlengang innerhalb des Korrektors in paraxialer Näherung anhand des Verlaufs der axialen Fundamentalbahnen (x_{α}), (y_{β}) und der außeraxialen Fundamentalbahnen (x_{γ}), (y_{δ}) wiedergegeben. Die Strahlrichtung weist von links nach rechts, sie ist durch den Pfeil 10 an der optischen Achse 4 des Systems angedeutet. Die linke Begrenzung der Figur kennzeichnet die Brennebene 11 hinter der Objektivlinse, die rechte die konjugierte Brennebene 12 hinter dem Korrektor. Mit dem Bezugszeichen 1, 2, 3 sind die erste, zweite und dritte Symmetrieebene des Korrektors angedeutet.

Wie der Figur zu entnehmen ist, bildet der Korrektor die Eintrittsebene 11 stigmatisch und unverzerrt in die Austrittsebene 12 ab. Wenn man dem Strahlengang der axialen Fundamentalbahnen (x_{α}), (y_{β}) und der außeraxialen Fundamentalbahnen (x_{γ}), (y_{δ}) durch den Korrektor folgt, erkennt man die hohe Symmetrie des Korrektors.

Bei Eintritt der Strahlen in den Korrektor bewirkt der eingangsseitig angeordnete Quadrupol Q1, dessen Position an der horizontalen Achse angedeutet ist, daß die im x- bzw. y-Schnitt verlaufenden Bahnen in unterschiedliche Richtungen abgelenkt werden. Das axiale bzw. außeraxialen Teilchenbündel wird hierdurch im y-Schnitt jeweils fokussiert, d.h. zur optischen Achse hin abgelenkt, während es im x-Schnitt jeweils aufgeweitet wird, d.h. von der optischen Achse weg abgelenkt wird. Die astigmatische Aufspaltung der Teilchenbündel bleibt beim Durchgang durch den ganzen Korrektor erhalten. Sie wird durch die nachfolgenden Quadrupole Q2, Q3, etc. jeweils um definierte Beträge verändert und erst beim Verlassen des Korrektors durch den Quadrupol Q1'" wieder aufgehoben.

Jede Dreiergruppe von Quadrupolelementen enthält für einen Schnitt zwei fokussierende und ein defokussierendes Element und für den anderen Schnitt ein fokussierendes und zwei defokussierende Elemente. Wie der Figur zu entnehmen werden hierdurch astigmatische Zwischenbilder erzeugt, die bei den axialen Fundamentalbahnen (x_{α}, (y_{β}) z. B. in der Mitte der Quadrupole Q2, Q2', Q2", Q2''' und am Ort der Oktopole 03, 03' in den Symmetrieebenen 1 bzw. 3 liegen. Das Zusammenspiel der Quadrupolelemente bewirkt insgesamt das beabsichtigte optische Verhalten des Korrektors bei der Korrektur der Farbfehler. Die optional vorgesehenen Quadrupole Q4, Q4' ermöglichen geringere elektrische Feldstärken bei gleicher oder sogar verbesserter Korrekturwirkung.

## Patentansprüche

1. Korrektor mit gerader optischer Achse (4) zur Beseitigung des Farbfehlers und des Öffnungsfehlers von teilchenoptischen Linsen, ausgestattet mit Multipolelementen in Form elektrischer und/oder magnetischer Quadrupol- und Oktopolelemente,
**dadurch gekennzeichnet, daß**
- wenigstens zwölf Quadrupolelemente (Q1 - Q3''') und zehn Oktopolelemente (01 - 04) vorgesehen sind,
- von denen je drei Quadrupolelemente (Q1, Q2, Q3) und zwei Oktopolelemente (O1, O2) zu einer Gruppe (G1 -G4) zusammengefaßt,
- und die Gruppen (G1 - G4) entlang der optischen Achse (4) hintereinander angeordnet sind,
- die Multipolelemente von Gruppe zu Gruppe sich jeweils paarweise einander entsprechen (Q1 und Q1', etc.),
- die Multipolelemente (Q3', Q2', Q1') der jeweils folgenden Gruppe (G2) jeweils in umgekehrter Reihenfolge entlang der optischen Achse (4) positioniert sind wie die entsprechenden Multipolelemente (Q1, Q2, Q3) der jeweils vorangehenden Gruppe (G1),
- und der Aufbau der jeweils einander entsprechenden Multipolelemente (Q1, Q1', etc. O1, O1', etc.) jeweils spiegelsymmetrisch zur jeweiligen Mittelebene (1, 2, 3) zwischen den Gruppen ist,
- die Mittelebene zwischen erster und zweiter Gruppe eine erste (1),
- die Mittelebene zwischen zweiter und dritter Gruppe eine zweite (2)
- und die Mittelebene zwischen dritter und vierter Gruppe eine dritte (3) Symmetrieebene definiert,
- wenigstens zwei Quadrupolelemente (Q1, Q2, etc.) elektrische und magnetische Quadrupolfelder erzeugen,
- wobei diese Quadrupolelemente vorzugsweise spiegelsymmetrisch zur zweiten (2) oder zu allen Symmetrieebenen (1, 2, 3) angeordnet sind,
- und jeweils ein weiteres Oktopolelement (O3, O3') in der ersten (1) und dritten (3) Symmetrieebene vorgesehen ist.

2. Korrektor nach Anspruch 1, **dadurch gekennzeichnet, dass** die Feldstärken der Quadrupole (Q1, Q2, Q3) derart gewählt sind, dass deren Brechkräfte symmetrisch zur ersten Symmetrieebene (1) und antisymmetrisch zur zweiten Symmetrieebene (2) eingestellt sind.

3. Korrektor nach Anspruch 1, **dadurch gekennzeichnet, dass** die Feldstärken der Quadrupole (Q1, Q2, Q3) derart gewählt sind, dass deren Brechkräfte symmetrisch zu den ersten und zweiten Symmetrieachsen (1, 2) eingestellt sind.

4. Korrektor nach einem der vorherigen Ansprüche, **dadurch gekennzeichnet, daß**
- die erste Gruppe (G1)
- eingangsseitig ein Quadrupolelement (Q1) zur Erzeugung von elektrischen und/oder magnetischen Quadrupolfeldern und in dessen unmittelbarer Nähe ein Oktopolelement (O1) aufweist,
- gefolgt von einem zweiten Quadrupolelement (Q2) zur Erzeugung von elektrischen und/oder magnetischen Quadrupolfeldern und einem Oktopolelement (O2) in dessen unmittelbarer Nähe,
- und ausgangsseitig ein Quadrupolelement (Q3) zur Erzeugung magnetischer und/oder elektrischer Quadrupolfelder angeordnet ist.

5. Korrektor nach einem der vohergehenden Ansprüche, **dadurch gekennzeichnet, daß**
- die Stärken der elektrischen und magnetischen Quadrupolfelder so eingestellt sind, daß
- sich der axiale Farbfehler und/oder der außeraxiale Farbfehler von Korrektor und genannter teilchenoptischer Linse jeweils ganz oder teilweise kompensieren.

6. Korrektor nach einem der vorhergehenden Ansprüche, **dadurch gekennzeichnet, dass** in jeder Gruppe (G1 - G4) jeweils ein weiteres Oktopolelement (O5, O5', usw.) zwischen den zweiten und dritten Quadrupolelementen (Q2 und Q3 bzw. Q2' und Q3', usw.) angeordnet ist.

7. Korrektor nach einem der vohergehenden Ansprüche, **dadurch gekennzeichnet, daß**
- die Stärken der genannten Oktopolelemente so eingestellt sind, daß die axialen und außeraxialen
- geometrischen Fehler 3. Ordnung von Korrektor und genannter teilchenoptischen Linse sich jeweils ganz oder teilweise kompensieren.

8. Korrektor nach einem der vorhergehenden Ansprüche, **dadurch gekennzeichnet, daß**
- in der zweiten Symmetrieebene (2) ein weiterer Oktopol (04) vorgesehen ist,
- und die Stärken der genannten Oktopolelemente (O1, O2, usw.) und die Stärke des weiteren Oktopols (O4) so eingestellt sind, daß
- der Öffnungsfehler 5. Ordnung von Korrektor und genannter teilchenoptischen Linse sich kompensieren.

9. Korrektor nach einem der vorhergehenden Ansprüche, **dadurch gekennzeichnet, daß**
- die Stärken der genannten Oktopolelemente so eingestellt sind, daß
- der Öffnungsfehler 3. Ordnung
- und/ oder der Öffnungsfehler 5. Ordnung
des aus Korrektor und genannter teilchenoptischen Linse bestehenden Gesamtsystems jeweils einen vorgebbaren Wert annehmen.

10. Korrektor nach einem der vorhergehenden Ansprüche 1 - 7, **dadurch gekennzeichnet, daß**
- ein Oktopolfeld (O1) einem Quadrupolfeld (Q1) überlagert ist.

11. Korrektor nach einem der vorhergehenden Ansprüche, **dadurch gekennzeichnet, daß**
- dasselbe Multipolelement sowohl ein Quadrupol- als auch ein Oktopolfeld erzeugt.

12. Verwendung des Korrektors nach einem der vorangehenden Ansprüche,
**dadurch gekennzeichnet, daß**
- er in einem vergrößernden teilchenoptischen System, vorzugsweise einem Transmissionselektronenmikroskop, eingesetzt wird
- und bei Blickrichtung in Strahlrichtung hinter dem Objektiv angeordnet ist.

13. Verwendung des Korrektors nach einem der vorangehenden Ansprüche,
**dadurch gekennzeichnet, daß**
- er in Elektronenmikroskopen mit großem Polschuhspalt, vorzugsweise der "in-situ"-Elektronenmikroskopie,
eingesetzt wird.

14. Verwendung des Korrektors nach einem der vorangehenden Ansprüche,
**dadurch gekennzeichnet, daß**
- er in verkleinernden optischen Systemen mit großem Bildfeld und vergleichsweise großer Energiebreite,
vorzugsweise der Elektronenprojektionslithographie,
eingesetzt wird.

15. Korrektor nach einem der vorhergehenden Ansprüche, **dadurch gekennzeichnet, daß** die Kombination mit der genannten teilchenoptischen Linse durch geeignete Wahl des Abstandes oder durch eine Transferoptik so erfolgt, daß der Korrektor die komafreie Ebene der Linse abbildet.

16. Korrektor nach Anspruch 17, **dadurch gekennzeichnet, dass** die Anpassung die Objektivlinse durch eine vergrößernde Transferoptik erfolgt.

17. Korrektor nach Anspruch 17, **dadurch gekennzeichnet, dass** die Anpassung an die Objektivlinse durch eine verkleinernde Transferoptik erfolgt.

18. Korrektor nach einem der vorhergehenden Ansprüche, **dadurch gekennzeichnet, daß** in der Symmetrieebene zwischen erster (G1) und zweiter (G2) Gruppe und zwischen dritter (G3) und vierter (G4) Gruppe jeweils ein weiterer magnetischer oder kombiniert elektrisch-magnetischer Quadrupol vorhanden ist.

19. Korrektor nach Anspruch 18, **dadurch gekennzeichnet, dass** die weiteren kombiniert elektrisch-magnetischen Quadrupole derart eingestellt sind, dass ihre Gesamtbrechkräfte in paraxialer Näherung kompensiert sind.

20. Korrektor nach einem der vorhergehenden Ansprüche, **dadurch gekennzeichnet, daß** unmittelbar aufeinander folgende Quadrupolelemente mit gleicher Erregung als ein Element ausgebildet werden.

## Claims

1. Corrector, comprising a rectilinear optical axis (4) for eliminating the chromatic aberration and the aperture aberration of particle-optical lenses, which is equipped with multipole elements in the form of electrical and/or magnetic quadrupole and octupole elements,
**characterised in that**
- at least twelve quadrupole elements (Q1-Q3''') and ten octupole elements (01-04) are provided,
- of which in each case three quadrupole elements (Q1, Q2, Q3) and two octupole elements (O1, O2) are collected to form a group (G1-G4),
- and the groups (G1-G4) are arranged one behind the other along the optical axis (4),
- the multipole elements from group to group in each case correspond to one another in pairs (Q1 and Q1', etc.),
- the multipole elements (Q3', Q2', Q1') of the respective following group (G2) are positioned in each case in reverse sequence along the optical axis (4) to the corresponding multipole elements (Q1, Q2, Q3) of the respective preceding group, (G1),
- and the construction and the fields of the respective mutually corresponding multipole elements (Q1, Q1', etc. O1, O1', etc.) are in each case constructed so as to be mirror symmetrical (1, 2, 3) to the respective central planes (1, 2, 3) between the groups,
- the central plane between the first and second groups defines a first (1),
- the central plane between the second and third groups defines a second (2),
- and the central plane between the third and fourth group defines a third (3) plane of symmetry,
- at least two quadrupole elements (Q1, Q2, etc.) generate electrical and magnetic quadrupole fields,
- these quadrupole elements preferably being arranged mirror symmetrically to the second (2) or to all planes of symmetry (1, 2, 3),
- and, in each case, a further octupole element (03, 03') being provided in the first (1) and third (3) planes of symmetry.

2. Corrector according to Claim 1, **characterised in that** the field intensities of the quadrupoles (Q1, Q2, Q3) are chosen such that their refractive powers are symmetrical to the first plane of symmetry (1) and antisymmetrically to the second plane of symmetry (2).

3. Corrector according to Claim 1, **characterised in that** the field intensities of the quadrupoles (Q1, Q2, Q3) are chosen such that their refractive powers are symmetrical to the first and second planes of symmetry (1, 2).

4. Corrector according to one of the preceding claims, **characterised in that**
- the first group (G1)
- has at the entry side a quadrupole element (Q1) for generating electrical and/or magnetic quadrupole fields and, in its immediate vicinity, an octupole element (O1).
- followed by a second quadrupole element (Q2) for generating electrical and magnetic quadrupole fields and, in the immediate vicinity thereof, an octupole element (O2).
- and a quadrupole element (Q3) for generating purely magnetic and/or electrical quadrupole fields is arranged at the output side.

5. Corrector according to one of the preceding claims, **characterised in that**
- the intensities of the electrical and magnetic quadrupole fields are adjusted such that
- the axial chromatic aberrations and/or the extra-axial chromatic aberrations of the corrector and of the aforementioned particle-optical lens in each case entirely or partly compensate one another.

6. Corrector according to one of the preceding claims, **characterised in that,** in each group (G1-G4), a further octupole element (O5, O5', etc.) in each case is arranged between the second and third quadrupole elements (Q2 and Q3 and Q2' and Q3', etc.).

7. Corrector according to one of the preceding claims, **characterised in that**
- the intensities of the aforementioned octupole elements are adjusted such that the axial and extra-axial
- 3rd order geometrical aberrations of corrector and of the aforementioned particle-optical lens in each case entirely or partially compensate one another.

8. Corrector according to one of the preceding claims, **characterised in that**
- in the second plane of symmetry (2), a further octupole (O4) is provided,
- and the intensities of the aforementioned octupole elements (O1, O2, etc.) and the intensity of the further octupole (O4) are adjusted such that
- the 5th order aperture aberration of the corrector and the aforementioned particle-optical lens compensate one another.

9. Corrector according to one of the preceding claims, **characterised in that**
- the intensities of the aforementioned octupole elements are adjusted such that
- the 3^{rd} order aperture aberration
- and/or the 5^{th} order aperture aberration
of the entire system comprising the corrector and the aforementioned particle-optical lens in each case assume a settable value

10. Corrector according to one of claims 1-7, **characterised in that**
- an octupole field (O1) is superimposed on a quadrupole field (Q1).

11. Corrector according to one the preceding claims, **characterised in that**
- one and the same multipole element generates both a quadrupole field and an octupole field.

12. Use of the corrector according to one of the preceding claims, **characterised in that**
- it is in particular used in an enlarging particle-optical system, preferably a transmission electron microscopy.
- and, as seen in the direction of the beam, is arranged behind the objective.

13. Use of the corrector according to one of the preceding claims, **characterised in that**
- it is used in electron microscopes with a large pole-shoe gap, preferably in "in situ" electron microscopy.

14. Use of the corrector according to one of the preceding claims, **characterised in that**
- it is used in diminishing optical systems with a large image field and comparatively large energy spread, preferably electron projection lithography.

15. Corrector according to one of the preceding claims, **characterised in that** the combination with the aforementioned particle-optical lens is carried out by a suitable choice of the distance or by means of transfer optics, such that the corrector forms an image of the coma-free plane of the lens

16. Corrector according to claim 17, **characterised in that** the adaptation of the objective lens is carried out by means of enlarging transfer optics.

17. Corrector according to claim 17, **characterised in that** the adaptation of the objective lens is carried out by means of diminishing transfer optics.

18. Corrector according to one of the preceding claims, **characterised in that** a further magnetic or combined electrical-magnetic quadrupole is present in each case in the plane of symmetry between the first (G1) and second (G2) group and between the third (G3) and fourth (G4) group.

19. Corrector according to claim 18. **characterised in that** the further combined electrical-magnetic quadrupoles are adjusted such that their total refractive powers are compensated in paraxial approximation.

20. Corrector according to one of the preceding claims, **characterised in that** quadrupole elements immediately following one another are designed with the same excitation as one element.

## Revendications

1. Correcteur avec un axe optique droit (4) destiné à corriger l'erreur de couleur et l'erreur d'ouverture de lentilles optiques à particules équipées d'éléments multipôles sous la forme d'éléments quadrupôles et octopôles électriques et/ou magnétiques,
**caractérisé par le fait**
• **qu'**au moins douze éléments quadrupôles (Q1 - Q3"') et dix éléments octopôles (O1 - O4) sont prévus,
• dont trois éléments quadrupôles (Q1, Q2, Q3) et deux éléments octopôles (O1, O2) sont à chaque fois rassemblés au sein d'un groupe (G1 - G4),
et les groupes (G1 - G4) sont disposés les uns derrière les autres le long de l'axe optique (4),
• les éléments multipôles se correspondent par paire les uns aux autres (Q1 et Q1', etc.),
• les éléments multipôles (Q3', Q2', Q1') de chaque groupe suivant (G2) sont positionnés dans chaque cas le long de l'axe optique (4) dans l'ordre inverse à celui des éléments multipôles correspondants (Q1, Q2, Q3) de chaque groupe précédent (G1),
• et la construction des différents éléments multipôles (Q1, Q1' etc. O1, O1', etc.) présente une symétrie réfléchie par rapport à chaque niveau médian (1, 2, 3) entre les groupes,
• le niveau médian entre le premier et le second groupe définissant un premier (1) niveau de symétrie,
• le niveau médian entre le second et le troisième groupe définissant un second (2) niveau de symétrie,
• et le niveau médian entre le troisième et le quatrième groupe définissant un troisième (3) niveau de symétrie,
• au moins deux éléments quadrupôles (Q1, Q2, etc.) produisant des champs magnétiques quadrupôles,
• sachant que ces éléments quadrupôles sont disposés avec une symétrie réfléchie par rapport à la seconde (2) ou à tous les niveaux de symétrie (1, 2, 3),
• et **qu'**un autre élément octopôle (O3, O3') est prévu dans le premier (1) et dans le troisième (3) niveau de symétrie.

2. Correcteur selon la revendication 1, **caractérisé par le fait que** les puissances des champs des quadrupôles (Q1, Q2, Q3) sont choisis de manière à ce que leurs forces de réfraction soient réglées de façon symétrique par rapport au premier niveau de symétrie (1) et antisymétrique par rapport au second niveau de symétrie (2).

3. correcteur selon la revendication 1 **caractérisé par le fait que** les puissances des champs des quadrupôles (Q1, Q2, Q3) sont choisis de façon à ce que leurs forces de réfraction soient réglées de façon symétrique par rapport au premier et au second axe de symétrie (1, 2).

4. Correcteur selon une des revendications précédentes,
**caractérisé par le fait**
• **que** le premier groupe (G1)
• présente, du côté de l'entrée, un élément quadrupôle (Q1) pour produire des champs électriques et/ou magnétiques quadrupôles, et à proximité immédiate un élément octopôle (01),
• suivi d'un deuxième élément quadrupôle (Q2) pour produire des champs électriques et/ou magnétiques quadrupôles, et à proximité immédiate un élément octopôle (O2),
• et **qu'**un élément quadrupôle (Q3) pour produire des champs électriques et/ou magnétiques quadrupôles est disposé du côté de la sortie.

5. Correcteur selon une des revendications précédentes,
**caractérisé par le fait que**
• les forces des champs électriques et magnétiques quadrupôles sont réglées de façon à ce que
• l'erreur axiale de couleur et/ou l'erreur extra-axiale de correcteur et de la lentille optique à particules citée se compensent dans chaque cas complètement ou partiellement.

6. Correcteur selon une des revendications précédentes,
**caractérisé par le fait qu'**un autre élément octopôle (O5, O5', etc.) est disposé à chaque fois entre le deuxième et le troisième élément quadrupôle ((Q2 et Q3 resp. Q2' et Q3', etc.).

7. Correcteur selon une des revendications précédentes, **caractérisé par le fait**
• **que** les forces des éléments octopôles sont réglées de façon à ce que les erreurs géométriques de 3^{ème} ordre de correcteur et de la lentille optique à particules citée se compensent à chaque fois complètement ou partiellement.

8. Correcteur selon une des revendications précédentes, **caractérisé par le fait**
• **qu'**un autre octopôle (O4) est prévu dans le second niveau de symétrie (2),
• et **que** les forces des éléments octopôles (O1, O2, etc.) et la force de l'autre octopôle (O4) sont réglées de façon à ce que
• les erreurs d'ouverture de 5^{ème} ordre de correcteur et de la lentille à particules citée se compensent.

9. Correcteur selon une des revendications précédentes, **caractérisé par le fait**
• **que** les forces des éléments octopôles sont réglés de façon à ce que
• **que** l'erreur d'ouverture de 3^{ème} ordre du système complet compensé du correcteur et de la lentille optique à particules adopte dans chaque cas une valeur pouvant être donnée en consigne.

10. Correcteur selon une des revendications précédentes 1-7,
**caractérisé par le fait**
• **qu'**un champ octopôle (01) est superposé à un champ quadrupôle (Q1).

11. Correcteur selon une des revendications précédentes,
**caractérisé par le fait**
• **que** le même élément multipôles produit à la fois un champ quadrupôle et un champ octopôle.

12. Utilisation du correcteur selon une des revendications précédentes, **caractérisée par le fait**
• **qu'**il est employé dans un système optique à particules grossissant, de préférence un microscope à transmission électronique
• et **qu'**il est disposé derrière l'objectif lorsqu'on regarde dans la direction du faisceau.

13. Utilisation du correcteur selon une des revendications précédentes, **caractérisée par le fait**
• **qu'**il est employé dans des microscopes électroniques ayant une grande fente du patin des pôles, de préférence dans le cadre de la microscopie électronique « in situ ».

14. Utilisation du correcteur selon une des revendications précédentes, **caractérisée par le fait**
• **qu'**il est employé dans des systèmes optiques réducteurs avec un grand champ de vision et une plage d'énergie relativement grande, de préférence dans le cadre de la lithographie à projection électronique.

15. Correcteur selon une des revendications précédentes, **caractérisé par le fait que** la combinaison de la lentille optique à particules citée s'effectue en choisissant de façon adaptée la distance ou à travers une optique de transfert de façon à ce que le correcteur figure le niveau sans coma de la lentille.

16. Correcteur selon la revendication 17, **caractérisé par le fait que** l'adaptation de la lentille de l'objectif s'effectue au moyen d'une optique de transfert grossissante.

17. Correcteur selon la revendication 17, **caractérisé par le fait que** l'adaptation à la lentille de l'objectif s'effectue au moyen d'une optique de transfert réductrice.

18. Correcteur selon une des revendications précédentes, **caractérisé par le fait qu'**il y a à la fois dans le niveau de symétrie du premier (G1) et du second (G2) groupe et dans le niveau de symétrie du troisième (G3) et du quatrième (G4) groupe un autre quadrupôle magnétique ou combiné électromagnétique.

19. Correcteur selon la revendication 18, **caractérisé par le fait que** les autres quadrupôles électromagnétiques combinés sont réglés de façon à ce que leurs forces complètes de réfraction soient compensées dans l'approche paraxiale.

20. Correcteur selon une des revendications précédentes, **caractérisé par le fait que** les éléments quadrupôles se suivant immédiatement les uns les autres sont constitués avec la même induction qu'un élément.
